(19) Europäisches Patentamt
European Patent Office
Office européen des brevets

(11) EP 3 306 354 B1

(12) EUROPEAN PATENT SPECIFICATION

(45) Date of publication and mention of the grant of the patent:
**22.12.2021 Bulletin 2021/51**

(51) Int Cl.:
*G02B 1/111* $^{(2015.01)}$ *B29D 11/00* $^{(2006.01)}$
*H01L 21/02* $^{(2006.01)}$

(21) Application number: **16306331.6**

(22) Date of filing: **07.10.2016**

(54) **ARTICLE COMPRISING A NANOLAMINATE COATING**

ARTIKEL MIT EINER NANOLAMINATBESCHICHTUNG

ARTICLE COMPRENANT UN REVÊTEMENT NANOLAMINÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.04.2018 Bulletin 2018/15**

(73) Proprietors:
- **Corporation de L'Ecole Polytechnique de Montreal**
  **Montréal, Québec H3T 1J4 (CA)**
- **Essilor International**
  **94220 Charenton-le-Pont (FR)**

(72) Inventors:
- **POIRIE, Thomas**
  **MONTREAL, Québec H3T 1J4 (CA)**
- **SCHMITT, Thomas**
  **MONTREAL, Québec H3T 1J4 (CA)**
- **MARTINU, Ludvik**
  **MONTREAL, Québec H3T 1J4 (CA)**
- **KLEMBERG-SAPIEHA, Jolanta**
  **MONTREAL, Québec H3T 1J4 (CA)**
- **SCHERER, Karin**
  **94227 CHARENTON LE PONT Cedex (FR)**
- **TROTTIER-LAPOINTE, William**
  **94227 CHARENTON-LE-PONT Cedex (FR)**
- **DEHOUX, Anita**
  **94227 CHARENTON-LE-PONT Cedex (FR)**

(74) Representative: **Jacobacci Coralis Harle**
**32, rue de l'Arcade**
**75008 Paris (FR)**

(56) References cited:
**EP-A1- 1 464 410 US-A1- 2016 139 304**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 306 354 B1

## Description

### TECHNICAL FIELD OF THE INVENTION

The invention concerns in general an article, such as an optical article, for example an ophthalmic lens, which comprises a nanolaminate coating having a low refractive index and good mechanical properties and in particular such an article comprising a nanolaminate coating comprising alternating inorganic silica and silicon-based organic-inorganic layers.

The present invention also concerns an interferential coating comprising alternating layers of low and high refractive index, at least one of the low refractive index layer being a nanolaminate coating according to the invention.

### BACKGROUND INFORMATION AND PRIOR ART

In the specific domain of optical coatings, plastics tend to progressively replace brittle glass substrate allowing obtaining flexible and lightweight devices. Polymeric substrates are indispensable in the roll-to-roll manufacturing of flexible devices such as organic light emitting diodes or packaging, this also includes the development of optically transparent gas barriers to avoid water or oxygen permeability responsible of optoelectronic devices or food packages degradation. Besides optical transparency, the main requirement in these two applications is the flexibility of the coating.

In other applications requiring optical coatings on plastics such as ophthalmic industry or, more recently, touch screen or screen protector industry, optical layers play a role in more complex interferential functions such as the anti-reflective effect. Stacks are formed, in most cases, of a succession of monolithic high and low refractive index layers, and the optical properties (refractive indexes and absorption) remain the main characteristics to control. Nevertheless, scratch and wear resistance and adhesion of the films is also very important as lenses or screens are subject to numerous tribological solicitations. Therefore, attention is increasingly devoted to the mechanical and tribological behavior during their design. Hence, the research has focused on the development of new low index organic material to replace the most commonly used low index $SiO_2$ brittle inorganic one, leading to the development of SiOCH coatings also known as organosilicate glass (OSG), or silicone. SiOCH coatings, commonly deposited via sol gel or plasma enhanced chemical vapor deposition (PECVD) processes, have proven to be a good flexible layer to replace $SiO_2$ in many applications, and they are nowadays used as low-k layer in electronic chips, flexible gas barriers for food packaging, or electronic device encapsulation. Recently, they have been introduced in Bragg mirrors or in antireflective filters on lenses and flexible solar cells.

Thus, Patel et al. in the article "Plasma-enhanced chemical vapor deposition synthesis of silica-silicone nanolaminates using a single precursor", J. Vac. Sci. Technol. A 29(2), Mar/Apr 2011, discloses silica/silicone nanolaminate coatings made by plasma-enhanced chemical vapor deposition (PEVCD) using a single precursor, hexamethyldisiloxane (HMDSO).

The SiOCH organic-inorganic layers are formed by using HMDSO only, whereas the $SiO_2$ mineral layers are formed by using HMDSO in the presence of oxygen ($O_2$).

The resulting nanolaminate coatings still have unsatisfactory mechanical properties. In particular, the coatings have unsatisfactory Young's modulus (E) and indentation hardness (H) leading to low H/E ratio, typically lower than 0.10.

Thus, the aim of the present invention is to provide an article, in particular an optical article such as an ophthalmic lens, comprising a nanolaminate coating of low refractive index which exhibits good mechanical properties.

### SUMMARY OF THE INVENTION

Thus, according to the invention, there is provided an article comprising a nanolaminate coating, wherein the nanolaminate coating has a total thickness ranging from 20 to 500 nm and comprises at least one pair of layers constituted of adjacent first and second layers and a minimum of three layers, said first layer being an inorganic silica layer obtained by evaporation of silicon oxide, especially evaporation of $SiO_2$, and the second layer being a silicon-based organic-inorganic layer obtained by deposition of an organosilicon compound or a mixture of organosilicon compounds under ionic or plasma assistance, and wherein the refractive index of the nanolaminate coating as a whole is lower than 1.58 at 550 nm.

In general, the nanolaminate coating is formed of alternated inorganic silica layer and silicon based organic-inorganic layer.

Preferably, the nanolaminate coating comprises at least two pairs of layers constituted of adjacent first and second layers and most preferably is solely constituted of a stack of pairs of first and second layers, the first layer of one pair of layers being adjacent to the second layer of another pair of layers (of course, except for the first pair of the stack formed on the article substrate).

Typically, the number of layers of the nanolaminate coating ranges up to 100, preferably up to 50, up to 30, up

to 20 and more preferably up to.10.

In some embodiment the number of layers of the nanolaminate coating is higher than or equal to 4, 5, 10, 20.

Usually, first and second layers of the nanolaminate coating have a thickness ranging from 5 nm and more, preferably up to 35 nm.

As already mentioned, the nanolaminate coating of the invention is a low refractive index coating, i.e. having as a whole a refractive index at 550 nm equal to or lower than 1.58, preferably equal to or lower than 1.57: 1.56; 1.55; 1.54 and most preferably equal to or lower than 1.53.

Typically, the first silica inorganic layer of the nanolaminate coating has a refractive index at 550 nm ranging from 1.44 to 1.50, preferably 1.46 to 1.50.

Typically, the second silicon-based organic-inorganic layer has a refractive index at 550 nm ranging from 1.50 to 1.58.

The ratio H/E of the indentation hardness (H) and the Young's modulus (E) of the nanolaminate coatings of the invention is generally higher than or equal to 0.10; 0.11; 0.12; 0.13; 0.135; 0.14 and preferably 0.145.

In an embodiment, the ratio H/E is lower than 0.16.

Typically, the Young's modulus (E) of the nanolaminate coating is higher than or equal to 26 GPa. Preferably, the Young's modulus (E) is higher than or equal to 27, 28 GPa and at most equal to 30 GPa.

Also, the nanolaminate coating of the invention has usually an indentation hardness (H) higher than or equal to 3.5 GPa and lower than or equal to 4.2 GPa. Preferably, the indentation hardness is equal to or higher than 3.6; 3.7 and most preferably 3.8.

The nanolaminate according to the invention may constitute at least one of the low refractive index layers of an interferential coating comprising alternating layers of low refractive index (LI) and high refractive index (HI).

It can also constitute the sublayer between a substrate and an antireflective stack of an optical article.

## BRIEF DESCRIPTION OF THE DRAWINGS

Figure 1 represents graphs a) and b) respectively of the refractive index n and extinction coefficient k as a function of the wavelengths in the visible range of nanolaminate coatings according to the invention having an overall thickness of 200 nm and one pair ($\Delta$ = 200 nm), two pairs ($\Delta$ = 100 nm), four pairs ($\Delta$ = 50 nm) and ten pairs ($\Delta$ = 20 nm) of first and second layers of the same thickness;

Figure 2 represents graphs of the Young's modulus (E) and of the nanoindentation hardness (H) of the nanolaminate coatings of Figure 1, in function of the number of nanolayers; and

Figure 3 is a graph of the elastic recovery (R) in function of the indentation hardness (H) and Young's modulus (E) ratio for the nanolaminate coatings of Figure 1.

## DETAILED DESCRIPTION OF THE INVENTION AND PREFERRED EMBODIMENTS

The terms "comprise" (and any grammatical variation thereof, such as "comprises" and "comprising"), "have" (and any grammatical variation thereof, such as "has" and "having"), "contain" (and any grammatical variation thereof, such as "contains" and "containing"), and "include" (and any grammatical variation thereof, such as "includes" and "including") are openended linking verbs. They are used to specify the presence of stated features, integers, steps or components or groups thereof, but do not preclude the presence or addition of one or more other features, integers, steps or components or groups thereof, although it preferably precludes the presence of one or more other features, steps or components or groups thereof. As a result, a method, or a step in a method, that "comprises," "has," "contains," or "includes" one or more steps or elements, possesses those one or more steps or elements, but is not limited to possessing only those one or more steps or elements, unless this is in contradiction to the subject matter of the appended claims, although it preferably possesses only those steps or elements.

Unless otherwise indicated, all numbers or expressions referring to quantities of ingredients, ranges, reaction conditions, etc. used herein are to be understood as modified in all instances by the term "about."

Also unless otherwise indicated, the indication of an interval of values « from X to Y » or "between X to Y", according to the present invention, means as including the values of X and Y.

In the present application, when an article such as an ophthalmic lens comprises one or more coatings onto the surface thereof, the expression "to deposit a layer or a coating onto the article" is intended to mean that a layer or a coating is deposited onto the external (exposed) surface of the article itself or the outer coating of the article, that is to say its coating which is the most distant from the substrate.

A coating, that is said to be "on" a substrate or deposited "onto" a substrate is defined as a coating, which (i) is positioned above the substrate, (ii) is not necessarily, although it is preferably, in contact with the substrate, that is to

say one or more intermediate coatings may be arranged between the substrate and the coating in question, and (iii) does not necessarily completely cover the substrate (although it preferably completely covers the substrate).

In a preferred embodiment, the coating on a substrate or deposited onto a substrate is in direct contact with this substrate.

When "a layer 1 is lying under a layer 2", it is intended to mean that layer 2 is more distant from the substrate than layer 1.

Although the article according to the invention can be of various nature as mentioned above, the hereinunder description is made in relation with optical articles and in particular ophthalmic lenses.

However, the particulars concerning the nanolaminate coatings and their making processes, as disclosed below, can obviously be used with other articles and substrates such as optoelectronic devices, image display devices, etc.

The article of the invention, preferably an optical article, typically comprises a substrate on which is deposited the nanolaminate coating.

For example, the article of the invention can be an ophthalmic lens which comprises a transparent substrate having two opposite main faces, at least one of which may be coated with a siloxane-based antiabrasion and/or antiscratch coating, hereinafter designated as hardcoat (HC).

The substrate of the lens according to the invention is preferably an organic substrate, for example made of thermoplastic or thermosetting plastic. This substrate may be chosen from the substrates mentioned in patent application WO 2008/062142.

In particular, thermoplastic materials may be selected from, for instance: polyamides, polyimide, polysulfones, polycarbonates and copolymers thereof, poly(ethylene terephtalate) and polymethylmethacrylate (PMMA).

Thermoset materials may be selected from, for instance: cycloolefin copolymers such as ethylene/norbornene or ethylene/cyclopentadiene copolymers ; homo- and copolymers of allyl carbonates of linear or branched aliphatic or aromatic polyols, such as homopolymers of diethylene glycol bis(allyl carbonate) (such as CR 39®) ; homo- and copolymers of (meth)acrylic acid and esters thereof, which may be derived from bisphenol A ; polymer and copolymer of thio(meth)acrylic acid and esters thereof, polymer and copolymer of allyl esters which may be derived from Bisphenol A or phtalic acids and allyl aromatics such as styrene, polymer and copolymer of urethane and thiourethane, polymer and copolymer of epoxy, and polymer and copolymer of sulphide, disulfide and episulfide, and combinations thereof.

Homopolymers of diethylene glycol bis(allyl carbonate) (suc as CR 39®), allylic and (meth)acrylic copolymers, having a refractive index between 1,54 and 1,58, and polythiourethanes are preferred.

As used herein, a (co)polymer is intended to mean a copolymer or a polymer. As used herein, a (meth)acrylate is intended to mean an acrylate or a methacrylate. As used herein, a polycarbonate (PC) is intended to mean either homopolycarbonates or copolycarbonates and block copolycarbonates.

Particularly recommended substrates include those substrates obtained through (co)polymerization of the diethyleneglycol bis-allyl-carbonate, marketed, for example, under the trade name CR-39® by the PPG Industries company, (examples of such kind of lenses are ORMA® lenses, ESSILOR), or through polymerization of the thio(meth)acrylate monomers, such as those described in the application of the French patent FR 2 734 827, or polythiourethanes The substrates may be obtained through polymerization of the above monomer combinations, or may further comprise mixtures of such polymers and (co)polymers.

Siloxane-based antiabrasion and/or antiscratch hardcoats are well known in the art.

Typically, such antiabrasion and/or antiscratch hardcoats are obtained from compositions comprising at least one alkoxysilane and/or hydrolysate thereof, obtained for example by hydrolysis with an hydrochloric acid solution. After hydrolysis step, which generally lasts for 1h to 24h, preferably 2 to 6h, condensation and/or curing catalysts can facultatively be added. A surfactant compound is also preferably added to improve optical quality of the deposit. Usually, the compositions comprise colloidal silica.

Among the recommended antiabrasion and/or antiscratch hardcoats, there may be cited the hardcoats elaborated from epoxy-silanes such as those disclosed in EP-0.614.957, US-4.211.833 and US-5.016.523.

Numerous examples of condensation and/or curing agents are given in the publications "Chemistry and Technology of the Epoxy Resins", B. Ellis (Ed.), Chapman Holl, New York, 1993 and "Epoxy resins and Technology", 2nd Edition C.A. May (Ed.) Marcel Dekker, New York, 1988.

A preferred composition for antiabrasion and/or antiscratch hardcoat is the composition disclosed in EP-0.614.957. It comprises a hydrolysate of trialkoxysilane and dialkyl dialkoxysilane, colloidal silica and a catalytic amount of an aluminum based curing catalyst such as aluminum acetyl acetonate. The remaining being essentially solvents classically used for formulating such compositions. Preferably, the used hydrolysate is hydrolysate of $\gamma$-glycidoxy propyl trimethoxy silane (GLYMO) and dimethyldiethoxysilane (DMDES).

The antiabrasion and/or antiscratch hardcoat composition can be deposited on the main face of the substrate by dipping or centrifugation. It is then cured in an appropriate manner (preferably heating and/or UV irradiation).

Thickness of the antiabrasion and/or antiscratch hardcoat ranges typically from 2 to 10 $\mu$m, preferably 3 to 5 $\mu$m.

Prior to the deposition of the hardcoat, there is usually deposited on the substrate main face an impact-resistance

primer.

Preferred impact-resistance primer compositions are thermoplastic polyurethane based compositions, as those disclosed in JP-63-141001 and JP-63-87223, poly(meth)acrylic compositions, as those disclosed in US-5.015.523, thermohardening polyurethane based composition, as those disclosed in EP-0.404.111, and poly(meth)acrylic latex or polyurethane latex based composition as those disclosed in US-5.316.791 and EP-0.680.492.Examples of polyurethane lattices are W234™ and W240™ from Baxenden.

These primer compositions are deposited by dipping or centrifugation and heat cured.

According to the invention, there is formed on the article substrate a nanolaminate coating as disclosed above which comprises alternating layers of mineral silica and silicon-based organic-inorganic material.

According to the invention, the organic-inorganic material is obtained by depositing, under an ion beam, activated species originating from at least one organosilicon compound or mixtures of organosilicon compounds.

Non-limiting examples of organosilicon compounds, cyclic or noncyclic, are the following compounds: octamethylcyclotetrasiloxane (OMCTS), decamethylcyclopentasiloxane, dodecamethylcyclohexasiloxane, hexamethyl cyclotrisiloxane, hexamethyldisiloxane (HMDSO), octamethyltrisiloxane, decamethyltetrasiloxane (DMTS), dodecamethylpentasiloxane, tetraethoxysilane, vinyltrimethylsilane, hexamethyldisilazane, hexamethyldisilane, hexamethylcyclotrisilazane, vinylmethyldiethoxysilane, divinyltetramethyl-disiloxane, tetramethyldisiloxane., polydimethylsiloxane (PDMS), polyphenylmethylsiloxane (PPMS) or a tetraalkylsilane such as tetramethylsilane.

Preferably, the organosilicon compound comprises at least one silicon atom carrying at least one alkyl group, preferably a C1 -C4 group, more preferably at least one silicon atom bearing one or two alkyl groups identical or different, preferably a C1-C4 group, for example a methyl group.

Preferred organosilicon compounds comprise a Si-O-Si group, preferably a divalent group of formula (3):

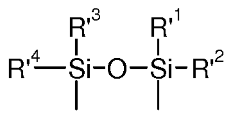

*formula (3)*

wherein $R'^1$ to $R'^4$ independently denote linear or branched alkyl or vinyl groups, preferably C1 - C4,groups, for example a methyl group, monocyclic or polycyclic aryl groups, hydroxyl or hydrolysable groups. Non-limiting examples of hydrolysable groups include H, halogen (chloro, bromo, iodo ...), alkoxy, aryloxy, acyloxy, - $NR^1$ $R^2$ wherein $R^1$ and $R^2$ independently denote a hydrogen atom, an alkyl or aryl group, and $-N(R^3)Si$ where $R^3$ is a hydrogen atom, a linear or branched alkyl group, preferably C1-C4 alkyl group or an aryl, monocyclic or polycyclic group,, preferably monocyclic. The groups with a Si-O-Si bond are not considered as "hydrolyzable groups" within the meaning of the invention. The preferred hydrolyzable group is the hydrogen atom.

According to another embodiment, the organosilicon compound has the formula:

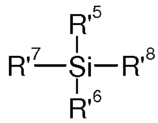

wherein $R'^5$, $R'^6$, $R'^7$, $R'^8$ independently denote hydroxyl groups or hydrolysable groups such as OR groups, wherein R is an alkyl group.

According to another embodiment of the invention, the organosilicon compound comprises at least one silicon atom carrying two identical or different alkyl groups, preferably a C1-C4 alkyl group. According to this first embodiment, the organosilicon compound is preferably a compound of formula (3) wherein $R'^1$ to $R'^4$ independently denote alkyl groups, preferably a C1-C4 alkyl group, for example a methyl group.

Preferably, the one or more silicon atoms of the organosilicon compound contain no hydrolyzable group or hydroxyl group in this embodiment.

Preferably, the one or more silicon atoms of the organosilicon compound is preferably bound only to alkyl groups and / or groups having -O- Si or -NH-Si to form an Si-O- Si or Si-NH-Si group. The preferred organosilicon compounds are DMTS, OMCTS and HMDSO.

In an embodiment, organosilicon compounds are cyclic polysiloxanes of formula (4):

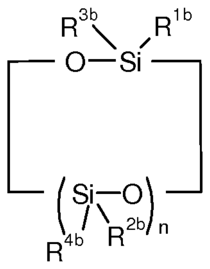

*formula (4)*

where n denotes an integer ranging from 2 to 20, preferably 3 to 8, R1b to R 4b independently represent linear or branched alkyl groups, preferably C1-4 group (e.g. methyl), vinyl, aryl or a hydrolyzable group. The preferred members of this group are the octa-alkylcyclotetrasiloxanes (n = 3), preferably octamethylcyclotetrasiloxane (OMCTS). In some cases, the layer is derived from a mixture of a number of compounds of formula (4) wherein n can vary within the limits indicated above.

In another embodiment, the organosilicon compound or mixture of organosilicon compounds, contains in its structure at least one Si-X group, where X is a hydroxy group or a hydrolyzable group chosen from the groups H, halogen, alkoxy, aryloxy, acyloxy, $-NR^1R^2$ where $R^1$ and $R^2$ designate independently a hydrogen atom, an alkyl group or an aryl group, and - $N(R^3)$-Si where $R^3$ designates an alkyl group or an aryl group or a hydrogen atom; at least one carbon atom; at least one hydrogen atom; and, optionally, at least one nitrogen atom and/or at least one oxygen atom. The definition of the groups $-NR^1R^2$ and $-N(R^3)$-Si indicated above naturally excludes compounds such as hexamethyldisilazane.

The organosilicon compound or mixture of organosilicon compounds preferably contains in its structure at least one Si-H group, i.e. is a silicon hydride. Preferably, the silicon atom of the group Si-X is not bonded to more than two non-hydrolyzable groups such as alkyl or aryl groups.

Among the groups X: the acyloxy groups have the formula $-O-C(O)R^4$ where $R^4$ is a preferably C6-C12 aryl group optionally substituted with one or more functional groups, or a linear or branched and preferably C1-C6 alkyl group optionally substituted with one or more functional groups and possibly furthermore comprising one or more double bonds, such as the phenyl, methyl or ethyl groups; the aryloxy and alkoxy groups have the formula $-O-R^5$ where $R^5$ is a preferably C6-C12 aryl group optionally substituted with one or more functional groups, or a linear or branched and preferably C1-C6 alkyl group optionally substituted with one or more functional groups and possibly furthermore comprising one or more double bonds, such as the phenyl, methyl or ethyl groups; the halogens are preferably F, Cl, Br or I; the groups X of formula $-NR^1R^2$ may designate an amino group $NH_2$ or an alkylamino, arylamino, dialkylamino or diarylamino group; $R^1$ and $R^2$ independently designate a hydrogen atom, a preferably C6-C12 aryl group optionally substituted with one or more functional groups, or a linear or branched and preferably C1-C6 alkyl group optionally substituted with one or more functional groups and possibly furthermore comprising one or more double bonds, such as the phenyl, methyl or ethyl groups; and the groups X of formula $-N(R^3)$-Si are attached to the silicon atom by way of their nitrogen atom and their silicon atom naturally comprises three other substituents, where $R^3$ designates a preferably C6-C12 aryl group optionally substituted with one or more functional groups, or a linear or branched and preferably C1-C6 alkyl group optionally substituted with one or more functional groups and possibly furthermore comprising one or more double bonds, such as the phenyl, methyl or ethyl groups.

The preferred acyloxy group is the acetoxy group. The preferred aryloxy group is the phenoxy group. The preferred halogen is Cl. The preferred alkoxy groups are the methoxy and ethoxy groups.

In an embodiment, the organosilicon compound or mixture of organosilicon compounds contains at least one nitrogen atom and/or at least one oxygen atom and preferably at least one oxygen atom.

The organosilicon compound or mixture of organosilicon compounds preferably contains at least one silicon atom bearing at least one, preferably C1-C4, alkyl group, better still at least one silicon atom bearing one or two identical or different, preferably C1-C4, alkyl groups, and a group X (preferably a hydrogen atom) directly bonded to the silicon atom, X having the meaning indicated above. The preferred alkyl group is the methyl group. The vinyl group may also be used instead of an alkyl group. Preferably, the organosilicon compound or mixture of organosilicon compounds comprises at least one Si-C bond and better still the silicon atom of the group Si-X is directly bonded to at least one carbon atom.

Preferably, each silicon atom of the organosilicon compound or mixture of organosilicon compounds is not directly bonded to more than two groups X, better still is not directly bonded to more than one group X (preferably a hydrogen atom), and better still, each silicon atom of the organosilicon compound or mixture of organosilicon compounds is directly bonded to a single group X (preferably a hydrogen atom). Preferably, the organosilicon compound or mixture of organosilicon compounds has a Si/O atomic ratio equal to 1. Preferably, the organosilicon compound or mixture of

organosilicon compounds has a C/Si atomic ratio <2, preferably ≤1.8, better still ≤ 1.6 and even better still ≤ 1.5 or ≤ 1.3 and optimally equal to 1. Again preferably, the organosilicon compound or mixture of organosilicon compounds has a C/O atomic ratio equal to 1. According to one embodiment, the organosilicon compound or mixture of organosilicon compounds does not comprise a Si-N group and better still does not comprise any nitrogen atoms.

The silicon atom or atoms of the organosilicon compound of a multilayered interferential coating are preferably only bonded to alkyl groups, hydrogen and/or groups containing an -O-Si or -NH-Si chain so as to form a Si-O-Si or Si-NH-Si group. In one embodiment, the organosilicon compound or mixture of organosilicon compounds contains at least one Si-O-Si-X group or at least one Si-NH-Si-X group, X having the meaning indicated above and preferably representing a hydrogen atom.

The organosilicon compound or mixture of organosilicon compounds of a multilayered interferential coating preferably contain a Si-O-Si group and more preferably a group of formula:

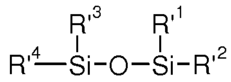

wherein R'1 to R'4 are independently linear or branched alkyl or vinyl groups, monocyclic or polycyclic aryl, hydroxyl groups or hydrolyzable groups.

According to another embodiment, the organosilicon compound or mixture of organosilicon compounds may be a cyclic polysiloxane of formula:

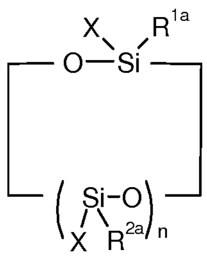

where X has the meaning indicated above and preferably represents a hydrogen atom, n designates an integer ranging from 2 to 20 and preferably from 3 to 8, and $R^{1a}$ and $R^{2a}$ independently represent a preferably C1-C4 alky group (for example the methyl group) or a vinyl or aryl group or a hydrolyzable group. Non-limiting examples of hydrolyzable groups for $R^{1a}$ and $R^{2a}$ are the chloro, bromo, alkoxy, acyloxy, aryloxy and H groups. The most common members belonging to this group are the tetra-, penta- and hexa-alkylcyclotetrasiloxanes, preferably the tetra-, penta- and hexa-methylcyclotetrasiloxanes, 2,4,6,8-tetramethylcyclotetrasiloxane (TMCTS) being the preferred compound.

According to another embodiment, the organosilicon compound or mixture of organosilicon compounds may be a linear alkylhydrosiloxane, better still a linear methylhydrosiloxane, such as for example 1,1,1,3,5,7,7,7-octamethyl tetrasiloxane, 1,1,1,3,5,5,5-heptamethyltrisiloxane or 1,1,3,3,5,5-hexamethyl trisiloxane.

Non-limiting examples of cyclic or non cyclic organosilicon compounds, in are the following compounds: 2,4,6,8-tetramethylcyclotetrasiloxane (TMCTS of formula (1)) The tétraéthylcyclotétrasiloxane 2,4,6,8-, 2,4,6, 8-tétraphénylcyclotétrasiloxane the 2,4,6,8-tétraoctylcyclotétrasiloxane the 2,2,4,6,6,8-hexaméthylcyclotétrasiloxane the 2,4,6-trimethylcyclotrisiloxane, cyclotetrasiloxane, 1, 3,5,7,9-pentamethyl cyclopentasiloxane, the hexaméthylcyclohexasiloxane-2,4,6,8,10, 1, 1, 1, 3,5,7 , 7,7-octamethyl cyclotetrasiloxane, 1, 1, 3,3,5,5-hexamethyltrisiloxane, tetramethyldisiloxane, tetraethoxysilane, vinylmethyldiethoxysilane, a hexamethylcyclotrisilazane such as hexamethylcyclotrisilazane 3,4,5,6 or 2, 2,4,4,6,6-hexamethylcyclotrisilazane, 1, 1, 1, 3,5,5,5- heptamethyl trisiloxane, tris (trimethylsiloxy) silane (formula (2)), 1, 1, 3 , 3-tetramethyldisilazane, 1, 2,3,4,5,6,7,8-octamethylcyclotetrasilazane, the nonaméthyl trisilazane, tris (dimethylsilyl) amine, hexamethyldisilazane.

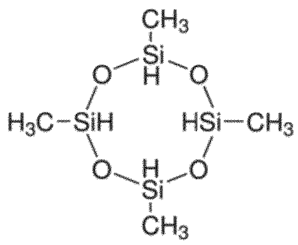 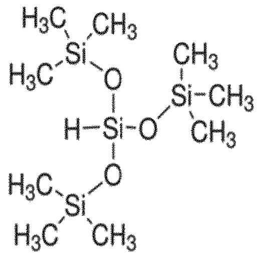

(1) (2)

The layer of silicon based organic-inorganic material obtained using the organosilicon compound of the invention is formed by vacuum deposition, consequently it does not include a hydrolyzate of organosilicon compound and therefore differs from the sol-gel coatings obtained by a liquid process.
The duration of the deposition process, the flow rates and pressures are adjusted to obtain the desired coating thickness.
The concentration of each chemical element (Si, O, C, H, N) in the layers of the invention obtained from an organosilicon compound may be determined using the Rutherford backscattering spectrometry technique (RBS) and elastic recoil detection analysis (ERDA).
In the layers of the invention, the atomic percentage may preferably range:

- for carbon atoms: from 1 to 25%, more preferably from 8 to 25% and even better from 15 to 25%.
- for hydrogen atoms: from 1 to 67%, more preferably from 8 to 40% and even better from 10 to 20%.
- for silicon atoms: from 8 to 33%, more preferably from 5 to 30% and even better from 15 to 25%.
- for oxygen atoms: from 6 to 67%, more preferably from 20 to 60% and even better from 35 to 45%.

As previously mentioned, the deposition step of the silicon-based organic-inorganic layers is performed by using the organosilicon compound or a mixture of organosilicon compounds described above by vacuum vapor deposition under plasma or a beam of ionized gas composition, preferably a beam of ionized gas composition.
Preferably, the beam of ionized gas composition is obtained from an ion gun.
According to an embodiment, the deposition is carried out in a vacuum chamber comprising an ion gun directed toward the substrates to be coated, which emits, toward said substrates, a beam of positive ions generated in a plasma within the ion gun. Preferably, the ions issued from the ion gun are particles formed from gas atoms from which one or more electrons have been stripped.
Since the layer of organic-inorganic material is formed by vacuum deposition, it does not contain any silane hydrolysate and therefore differs from sol-gel coatings obtained by liquid processing.
In general, the ionized gas composition used during the deposition step of the LI layer comprises oxygen ($O_2$). In an embodiment, it can be a mixture of $O_2$/Ar. Preferably the ionized gas composition from the ion gun comprises only Oxygen.
In another embodiment, the ionized gas comprises $N_2$.
The organosilicon compound or mixture of organosilicon compounds is introduced, in a gaseous state into the vacuum chamber, preferably in a direction that crosses the ion beam, and is activated under the effect of the ion gun. In other words, it is preferably not vaporized inside the vacuum chamber. The feed of the organosilicon compound or mixture of organosilicon compounds of the multilayered interferential coating is preferably located a distance away from the exit of the ion gun preferably ranging from 30 cm to 200 cm.
This deposition technique using an ion gun and a gaseous precursor, sometimes referred to as "ion beam deposition", is especially described in patent US 5,508,368.
According to an embodiment of the invention, the ion gun is the only place in the chamber where a plasma is generated.
According to another embodiment of the invention, a plasma coming from the ion gun is present in the chamber.
The ions may, if required, be neutralized before they exit the ion gun. In this case, the bombardment is still considered to be ion bombardment. The ion bombardment causes atomic rearrangement in and a densification of the layer being deposited, tamping it down while it is being formed.
During the implementation of the process according to the invention, the surface to be treated is preferably bombarded by ions with a current density generally comprised between 20 and 1000 $\mu A/cm^2$, preferably between 30 and 500 $\mu A/cm^2$, more preferably between 30 and 200 $\mu A/cm^2$ and typically 50 to 200 $\mu A/cm^2$, mor preferably 100 to

200 μA/cm$^2$ at the activated surface and generally under a residual pressure in the vacuum chamber possibly ranging from $6\times10^{-5}$ mbar to $5\times10^{-4}$ mbar and preferably from $8\times10^{-5}$ mbar to $2\times10^{-4}$ mbar.

The lower pressures mentioned above are generally used during IPC (ion precleaning) of the surface before depositing the layers.

The pressure during evaporation and deposition of the organosilicon compounds is preferably ranging from $10^{-4}$ mbar to $3\times10^{-3}$ mbar, more preferably from $3\times10^{-4}$ mbar to $1.5\times10^{-3}$ mbar.

The evaporation of the organosilicon compounds of the layer of organic-inorganic material, carried out under vacuum, may be achieved using a joule heat source.

As previously indicated, the inorganic silica layers of the nanolaminate coating of the invention are obtained by evaporation of silicon oxide, especially $SiO_2$.

Such a deposition process is well known in the art.

Preferably, no organosilicon compound, more preferably no organic-inorganic compound, even better no organic compound is deposited during deposition of the inorganic silica layer.

Evaporation of silicon oxide is usually performed using an electron beam and optionally assisted by ion beam.

Optionally, silicon oxide can be doped with $Al_2O_3$, typically up to 8% by weight.

The invention is illustrated in a non-limiting way by the following examples:

EXAMPLES

## 1. Experimental methodology

### 1.1 Sample preparation

Nanolaminates were deposited in a box coater system (BOXER PRO, Leybold Optics). They consist of a succession of two different low index materials, namely, purely mineral $SiO_2$ and organic-inorganic SiOCH transparent films. $SiO_2$ material was evaporated using an e-beam evaporation source (electron beam gun HPE 6 - High Performance Evaporator, Leybold Optics) as described in article "In situ real time nanowear testing method of optical functional films", T. Poirié et al., Tribology International, Vol. 95, pp. 147-155, 2016, while the octamethylcyclotetrasiloxane (OMCTS) organic-inorganic compound was decomposed using a gridless End-Hall ion source (EH-1000, Kaufman & Robinson Inc.) in order to form the organic-inorganic SiOCH layers as described In WO2013098531 and "Hybrid Organic-Inorganic Optical Films Deposited by Ion Beam Assisted CVD", O. Zabeida et al., Optical Interference Coatings, 2013, p, Th A.4.

During deposition of organic-inorganic SiOCH layers, the ion gun anode current was set at 3A and the anode voltage was automatically adjusted to keep this anode current constant. Oxygen and argon gases were introduced in the chamber with a 10 sccm flow rate. In the meantime, the OMCTS compound flow rate was set at 25 sccm resulting in a working pressure in the vacuum chamber of 0.44 mTorr.

Six types samples were prepared in this study. A base layer of 200nm for each material was deposited to be used as references, while four nanolaminates structures were deposited for the purpose of this study. The overall thickness is set at 200nm, and the number of sub-layers in the structure was set as 2, 4, 8 and 20. This results in four coatings containing sub-layers of 100 nm ($\Delta$=200 nm), 50 nm ($\Delta$=100nm), 25 nm ($\Delta$=50 nm) and 10 nm ($\Delta$=20 nm), respectively.

All samples were deposited on crystalline silicon substrates for the evaluation of the film thickness, optical properties and mechanical properties, while ophthalmic plastic substrates (CR39® from PPG) coated with a protective hardcoat of a thickness of about 3.2 μm, as disclosed in the experimental section of the patent application WO-2010/109154, were used for the scratch and the nanowear testing. The hardcoat is the one disclosed in example 3 of EP.614957. Before deposition, all substrates were cleaned using a dry nitrogen flow gun in order to remove dust and particulates from the surface.

### 1.2 Optical characterization

Thickness (d), refractive index (n) and extinction coefficient (k) measurements

Variable angle spectroscopic ellipsometry (RC2 (2 rotating compensators), J.A. Woollam Company, Inc.) was employed to measure the optical response of the samples and the data were analyzed using Complete EASE software (J.A. Woollam Company, Inc) The measurements were performed at different angles of incidence from 45° to 75° with 10°. Samples with the two base materials were analyzed first using a Gaussian oscillator in order to extract their optical properties. Thereafter these properties were employed in two different ellipsometric models in order to obtain the optical response of the laminate structures. The first model is based on effective medium approximation (EMA) where all structures are considered as a single layer formed of a mix of the two base materials. This model allows one to obtain thickness (d), refractive index (n) and extinction coefficient (k) of the whole structure by fitting the whole thickness and

the portion of each material in the coating. The second model consists in a laminate structure (2, 4, 8 or 10 layers) where optical properties of each layer correspond to the properties of the base materials. In this second model, all sub-layers made of the same material are linked together and the only fitting parameter is the thickness of the sub-layers.

In addition to the above modes, It s also possible to make the calculations based on the refractive index dispersion Cauchy model as a first evaluation.

1.3 Tribo-mechanical characterization

Nanoindentation

A triboindenter TI 950 system (Hysitron, Inc.) equipped with a Berkovich tip was employed in order to determine the mechanical properties of the coatings (i.e., the Young's modulus (E), the Hardness (H) and the elastic recovery, R) by the depth-sensing indentation technique.

Prior to measurement, the machine compliance was calibrated following the ISO 14577-2 standard, and the area function of the Berkovich Diamond tip was determined by performing several matrix indentations in the fused quartz reference block. Four matrix of 25 indentations were made using maximum load ranging from 100μN to 1000μN, and one matrix of 100 indentations was made using loads between 100μN and 9300μN (the maximum load of the apparatus). This methodology allows one to obtain more information for small penetration depth where the error in the determination of the indenter shape might be important.

After calibrations, two matrixes of 25 indentations were performed on each sample with maximum applied loads ranging from 100μN to 9300μN. The corresponding penetration depth between 10 and 200 nm enabled one to visualize of tip rounding effects and the substrate influence. The first indentation is made at the highest load while for each subsequent indentation the load is incrementally decreased by a constant percentage down to 100μN in order to obtain a higher concentration of indentations at low load. The loading function employed consisted of a loading segment of 5s, a holding period at maximum load of 2s, and an unloading segment of 5s. From these measurements, the indentation cycles were analyzed using the Oliver and Pharr approach disclosed in "Improved technique for determining hardness and elastic modulus using load displacement sensing indentation experiments", Journal of Materials Research, Vol. 7, pp. 1564-1583, 1992. Subsequently, ISO 14577-4 standard was used to extract the (E) and (H) characteristics of the films. First, the stiffness of the contact is obtained by fitting a power law function to the unloading curve and extracting the slope of the fit at the beginning of the unloading phase. The contact depth is then estimated and the corresponding contact area is used to calculate $E_r$ and H of each indentations. ISO 14577-4 standard (I. O. f. Standardization, "Metallic materials -- Instrumented indentation test for hardness and materials parameters -- Part 4: Test method for metallic and non-metallic coatings," in ISO 14577-4, ed. Geneva, Switzerland: International Organization for Standardization 2007) is used to extract the mechanical properties $E_r$ and H of the films

R is evaluated by dividing the reversible work of indentation ($W_e$) over the total work of indentation ($W_{total}$) (equation1). In this study, R is determined using indentations made with a 1000 μN maximum applied load for all sample in order to obtain a contact depth greater than the round part of the tip whilst having small enough penetration depth to minimize the substrate effect.

$$R = \frac{W_e}{W_{total}} \ [\%] \qquad (1)$$

**2. Results and discussion**

2.1 Optical properties

Figure 1 shows the evolution of n and k over the wavelength range obtained from the EMA model. Optical properties of the nanolaminates structure are an average of the two base materials ($SiO_2$ and SiOCH), and the period (Δ) in the structure does not affect the overall optical properties of the coating. It can be seen that nanostructures of the invention exhibit much lower refractive indexes than monolithic organic-inorganic layers of the same thickness (200 nm).

2.2 Tribomechanical properties

Nanoindentation

Figure 2 shows the evolution of E and H as a function of the number of sublayers in the coating. One can note that the E and H values of the structured films decrease linearly with the number of layer in the structure, and then their

maximum is obtained for a film having two or four layers while their minimum is obtained for a structure having most layers (twenty). E maximum value, 30 GPa, is close to the average modulus value of a 50-50 mixture of $SiO_2$ (37 GPa) and SiOCH (26 GPa). It decreases down to 26 GPa corresponding to the modulus of the top layer, i.e. SiOCH. In the meantime, the hardness reaches its maximum value for the structure constituted of 2-4 layers. Maximum hardness of the nanolaminate corresponds roughly to the hardness of the SiOCH top layer (around 4.2 GPa), and the hardness of the coating decreases to a value close to an average between $SiO_2$ and SiOCH (3.9 GPa) as the number of layer in the coating increases. It appears that the hardness is less influenced by the structuring than the modulus. Hardness is around 4 GPa for the entire structured layer; this is much higher than the hardness of the $SiO_2$ layer (3.5 GPa), but only slightly lower compared to the hardness of the SiOCH layer (4.2 GPa).

Another important parameter in the mechanical properties is the elastic recovery which corresponds to the portion of the given back total energy returned following the indentation test. The higher the elastic recovery, the less permanent deformation remains after the test. As shown in Figure 3, the value varies from that for a 50%($SiO_2$)50%(SiOCH) mixture to a value for the SiOCH coating. Decreasing the thickness of the sublayer allows one to enhance R and H/E ratio of the structure, usually linked to better tribo-mechanical performance.

## Claims

1. Article comprising a nanolaminate coating, wherein the nanolaminate coating has a total thickness ranging from 20 to 500 nm and comprises at least one pair of layers constituted of adjacent first and second layers and a minimum of three layers, said first layer being an inorganic silica layer obtained by evaporation and deposition of silicon oxide, especially $SiO_2$, and the second layer being a silicon-based organic-inorganic layer obtained by deposition of an organosilicon compound or a mixture of organosilicon compounds under ionic or plasma assistance, and wherein the refractive index of the nanolaminate coating as a whole is lower than 1.58 at 550 nm.

2. Article according to claim 1, wherein the nanolaminate coating comprises at least two pairs of layers constituted of adjacent first and second layers.

3. Article according to claim 1 or 2, wherein the number of layers of the nanolaminate coating ranges up to 100, preferably up to 50 and more preferably up to 30.

4. Article according to any of claims 1 to 3, wherein the physical thickness of first and second layers of the pair of layers is of 5 nm or more.

5. Article according to any of claims 1 to 4, wherein the nanolaminate coating layers have a maximum physical thickness of 35 nm.

6. Article according to any of claims 1 to 5, wherein the nanolaminate coating as a whole has refractive index at 550 nm equal to or lower than 1.57.

7. Article according to any of claims 1 to 6, wherein the refractive index at 550 nm of the first inorganic silica layer is ranging from 1.44 to 1.50.

8. Article according to any of claims 1 to 7, wherein the refractive index at 550 nm of the silicon-based organic-inorganic layer is ranging from 1.50 to 1.58.

9. Article according to any of claims 1 to 8, wherein the ratio H/E of the indentation hardness (H) and Young's modulus (E) of the nanolaminate coating is higher than or equal to 0.10.

10. Article according to claim 9, wherein the ratio H/E of the nanolaminate coating is lower than 0.16.

11. Article according to any of claims 1 to 10, wherein the nanolaminate coating has a Young's modulus (E) lower than or equal to 26 GPa.

12. Article according to any of claims 1 to 11, wherein the nanolaminate coating has an indentation hardness (H) higher than 3.5 GPa and lower than or equal to 4.2 GPa.

13. Article according to claim 12, wherein the nanolaminate coating has an indentation hardness (H) higher than 3.6.

14. Article according to any of claims 1 to 13, wherein the organosilicon compound is selected from the group consisting of octamethylcyclotetrasiloxane (OMCTS), decamethylcyclopentasiloxane, dodecamethylcyclohexasiloxane, hexamethylcyclotrisiloxane, hexamethyldisiloxane (HMDSO), octamethyl-trisiloxane, decamethyltetrasiloxane (DMTS), dodecamethylpentasiloxane, vinyltrimethylsilane, hexamethyldisilazane, hexamethyldisilane, hexamethyl-cyclotrisilazane, vinylmethyldiethoxysilane, divinyltetramethyldisiloxane, tetramethyldisiloxane, polydimethylsiloxane (PDMS), polyphenylmethylsiloxane (PPMS) or a tetraalkylsilane, in particular tetramethylsilane, and preferably among decamethyltetrasiloxane, octamethylcyclotetrasiloxane and hexamethyldisiloxane.

15. Interferential coating comprising alternating layers of low refractive index (LI) and high refractive index (HI), wherein at least one of the LI layers is a nanolaminate coating according to any of the preceding claims.

## Patentansprüche

1. Artikel mit einer Nanolaminatbeschichtung, wobei die Nanolaminatbeschichtung eine Gesamtdicke im Bereich von 20 bis 500 nm hat und mindestens ein Paar Schichten, gebildet aus benachbarten ersten und zweiten Schichten, und ein Minimum von drei Schichten umfasst, wobei die erste Schicht eine anorganische Siliciumdioxidschicht ist, die durch Verdampfen und Abscheiden von Siliciumoxid, insbesondere $SiO_2$, erhalten wird, und die zweite Schicht eine organischanorganische Schicht auf Siliciumbasis ist, die durch Abscheiden einer Organosiliciumverbindung oder Mischung von Organosiliciumverbindungen mit ionischer oder Plasmaunterstützung erhalten wird, und wobei der Brechungsindex der Nanolaminatbeschichtung als ganzes niedriger als 1,58 bei 550 nm ist.

2. Artikel nach Anspruch 1, wobei die Nanolaminatbeschichtung mindestens zwei Paare von Schichten umfasst, die aus benachbarten ersten und zweiten Schichten gebildet sind.

3. Artikel nach Anspruch 1 oder 2, wobei die Anzahl der Schichten der Nanolaminatbeschichtung im Bereich bis zu 100, vorzugsweise bis zu 50 und bevorzugter bis zu 30 liegt.

4. Artikel nach einem der Ansprüche 1 bis 3, wobei die physische Dicke der ersten und zweiten Schichten des Paares von Schichten 5 nm oder mehr beträgt.

5. Artikel nach einem der Ansprüche 1 bis 4, wobei die Nanolaminatbeschichtungsschichten eine maximale physische Dicke von 35 nm haben.

6. Artikel nach einem der Ansprüche 1 bis 5, wobei die Nanolaminatbeschichtung als ganzes einen Brechungsindex bei 550 nm gleich oder niedriger als 1,57 hat.

7. Artikel nach einem der Ansprüche 1 bis 6, wobei der Brechungsindex der ersten anorganischen Siliciumdioxidschicht bei 550 nm im Bereich von 1,44 bis 1,50 liegt.

8. Artikel nach einem der Ansprüche 1 bis 7, wobei der Brechungsindex der organisch-anorganischen Schicht auf Siliciumbasis bei 550 nm im Bereich von 1,50 bis 1,58 liegt.

9. Artikel nach einem der Ansprüche 1 bis 8, wobei das Verhältnis H/E der Eindruckhärte (H) und des Young-Moduls (E) der Nanolaminatbeschichtung größer als oder gleich 0,10 ist.

10. Artikel nach Anspruch 9, wobei das Verhältnis H/E der Nanolaminatbeschichtung kleiner als 0,16 ist.

11. Artikel nach einem der Ansprüche 1 bis 10, wobei die Nanolaminatbeschichtung einen Young-Modul (E) kleiner als oder gleich 26 GPa hat.

12. Artikel nach einem der Ansprüche 1 bis 11, wobei die Nanolaminatbeschichtung eine Eindruckhärte (H) größer als 3,5 GPa und kleiner als oder gleich 4,2 GPa hat.

13. Artikel nach Anspruch 12, wobei die Nanolaminatbeschichtung eine Eindruckhärte (H) größer als 3,6 hat.

14. Artikel nach einem der Ansprüche 1 bis 13, wobei die Organosiliciumverbindung ausgewählt ist aus der Gruppe bestehend aus Octamethylcyclotetrasiloxan (OMCTS), Decamethylcyclopentasiloxan, Dodecamethylcyclohexasiloxan, Hexamethylcyclotrisiloxan, Hexamethyldisiloxan (HMDSO), Octamethyltrisiloxan, Decamethyltetrasiloxan (DMTS), Dodecamethylpentasiloxan, Vinyltrimethylsilan, Hexamethyldisilazan, Hexamethyldisilan, Hexamethylcyclotrisilazan, Vinylmethyldiethoxysilan, Divinyltetramethyldisiloxan, Tetramethyldisiloxan, Polydimethylsiloxan (PDMS), Polyphenylmethylsiloxan (PPMS) oder einem Tetraalkylsilan, insbesondere Tetramethylsilan, und vorzugsweise ausgewählt ist aus Decamethyltetrasiloxan, Octamethylcyclotetrasiloxan und Hexamethyldisiloxan.

**15.** Interferenzbeschichtung, die alternierende Schichten mit niedrigem Brechungsindex (LI) und hohem Brechungsindex (HI) umfasst, wobei mindestens eine der LI-Schichten eine Nanolaminatbeschichtung gemäß einem der vorhergehenden Ansprüche ist.

## Revendications

**1.** Article comprenant un revêtement nanostratifié, le revêtement nanostratifié ayant une épaisseur totale dans la plage de 20 à 500 nm et comprenant au moins une paire de couches constituée de première et deuxième couches adjacentes et d'un minimum de trois couches, ladite première couche étant une couche de silice inorganique obtenue par évaporation et dépôt d'oxyde de silicium, notamment de $SiO_2$, et la deuxième couche étant une couche organique-inorganique à base de silicium obtenue par dépôt d'un composé d'organosilicium ou d'un mélange de composés d'organosilicium sous assistance ionique ou plasma, et l'indice de réfraction du revêtement nanostratifié dans son ensemble étant inférieur à 1,58 à 550 nm.

**2.** Article selon la revendication 1, le revêtement nanostratifié comprenant au moins deux paires de couches constituées de première et deuxième couches adjacentes.

**3.** Article selon la revendication 1 ou 2, le nombre de couches du revêtement nanostratifié allant jusqu'à 100, préférablement jusqu'à 50 et plus préférablement jusqu'à 30.

**4.** Article selon l'une quelconque des revendications 1 à 3, l'épaisseur physique des première et deuxième couches de la paire de couches étant de 5 nm ou plus.

**5.** Article selon l'une quelconque des revendications 1 à 4, les couches de revêtement nanostratifié ayant une épaisseur physique maximale de 35 nm.

**6.** Article selon l'une quelconque des revendications 1 à 5, le revêtement nanostratifié dans son ensemble ayant un indice de réfraction à 550 nm égal ou inférieur à 1,57.

**7.** Article selon l'une quelconque des revendications 1 à 6, l'indice de réfraction à 550 nm de la première couche de silice inorganique se situant dans la plage de 1,44 à 1,50.

**8.** Article selon l'une quelconque des revendications 1 à 7, l'indice de réfraction à 550 nm de la couche organique-inorganique à base de silicium se situant dans la plage de 1,50 à 1,58.

**9.** Article selon l'une quelconque des revendications 1 à 8, le rapport H/E de la dureté par indentation (H) et du module de Young (E) du revêtement nanostratifié étant supérieur ou égal à 0,10.

**10.** Article selon la revendication 9, le rapport H/E du revêtement nanostratifié étant inférieur à 0,16.

**11.** Article selon l'une quelconque des revendications 1 à 10, le revêtement nanostratifié possédant un module de Young (E) inférieur ou égal à 26 GPa.

**12.** Article selon l'une quelconque des revendications 1 à 11, le revêtement nanostratifié possédant une dureté par indentation (H) supérieure à 3,5 GPa est inférieure ou égale à 4,2 GPa.

**13.** Article selon la revendication 12, le revêtement nanostratifié possédant une dureté par indentation (H) supérieure à 3,6.

**14.** Article selon l'une quelconque des revendications 1 à 13, le composé d'organosilicium étant choisi dans le groupe constitué par l'octaméthylcyclotétrasiloxane (OMCTS), le décaméthylcyclopentasiloxane, le dodécaméthylcyclohexasiloxane, l'hexaméthylcyclotrisiloxane, hexaméthyldisiloxane (HMDSO), l'octaméthyl-trisiloxane, le décaméthyltétrasiloxane (DMTS), le dodécaméthylpentasiloxane, le vinyltriméthylsilane, l'hexaméthyldisilazane, l'hexaméthyldisilane, l'hexaméthyl-cyclotrisilazane, le vinylméthyldiéthoxysilane, le divinyltétraméthyldisiloxane, le tétraméthyldisiloxane, un polydiméthylsiloxane (PDMS), un polyphénylméthylsiloxane (PPMS) et un tétraalkylsilane, en particulier le tétraméthylsilane, et préférablement parmi le décaméthyltétrasiloxane, l'octaméthylcyclotétrasiloxane et l'hexaméthyldisiloxane.

**15.** Revêtement interférentiel comprenant des couches alternées à indice de réfraction bas (LI) et à indice de réfraction élevé (HI), au moins l'une parmi les couches à LI étant un revêtement nanostratifié selon l'une quelconque des revendications précédentes.

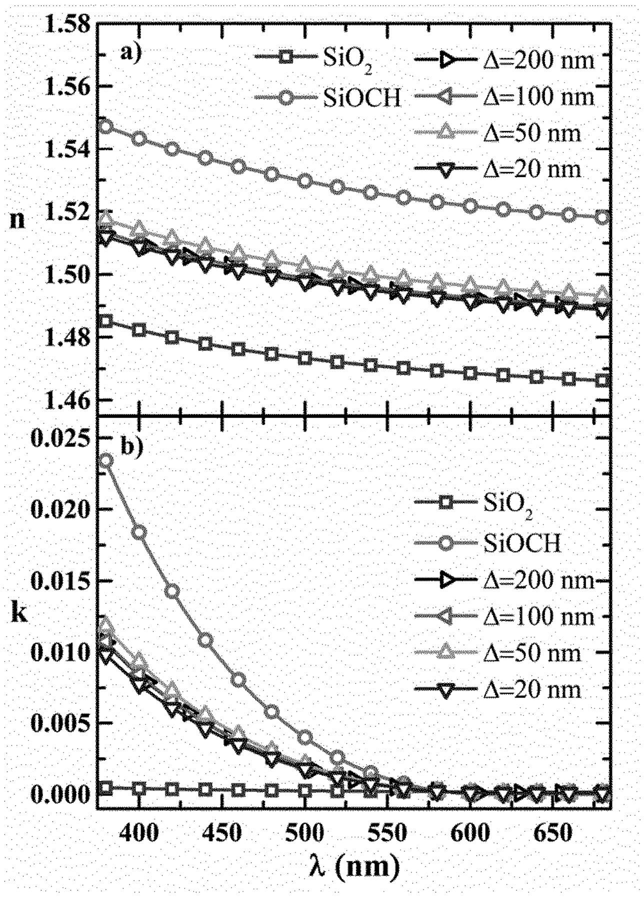


FIGURE 1

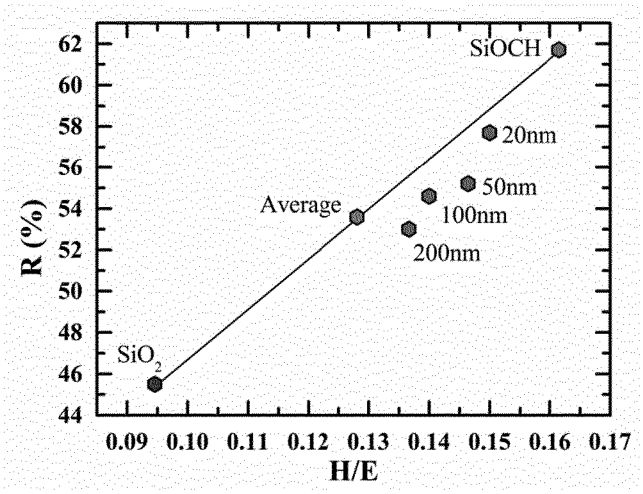


FIGURE 3

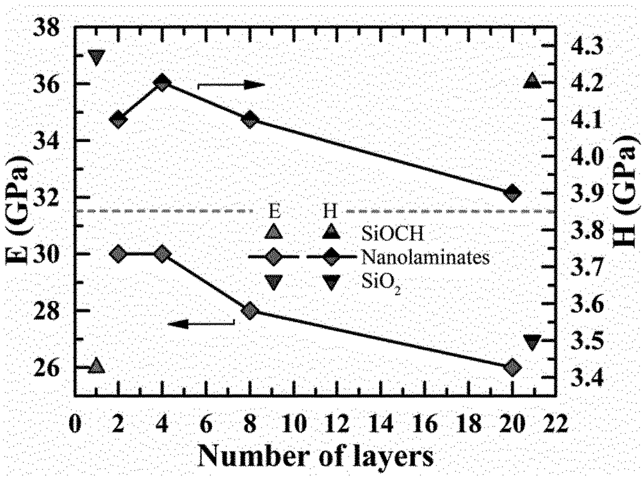
E (GPa)
H (GPa)
Number of layers
E H
SiOCH
Nanolaminates
SiO2
38
36
34
32
30
28
26
4.3
4.2
4.1
4.0
3.9
3.8
3.7
3.6
3.5
3.4
0 2 4 6 8 10 12 14 16 18 20 22

FIGURE 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2008062142 A
- FR 2734827
- EP 0614957 A
- US 4211833 A
- US 5016523 A
- JP 63141001 A
- JP 63087223 A
- US 5015523 A
- EP 0404111 A
- US 5316791 A
- EP 0680492 A
- US 5508368 A
- WO 2013098531 A
- WO 2010109154 A
- EP 614957 A


### Non-patent literature cited in the description


- **THUS ; PATEL et al.** Plasma-enhanced chemical vapor deposition synthesis of silica-silicone nanolaminates using a single precursor. *J. Vac. Sci. Technol. A,* March 2011, vol. 29 (2
- Chemistry and Technology of the Epoxy Resins. Chapman Holl, 1993
- Epoxy resins and Technology. Marcel Dekker, 1988
- **T. POIRIÉ et al.** In situ real time nanowear testing method of optical functional films. *Tribology International,* 2016, vol. 95, 147-155
- **O. ZABEIDA et al.** Hybrid Organic-Inorganic Optical Films Deposited by Ion Beam Assisted CVD. *Optical Interference Coatings,* 2013
- Improved technique for determining hardness and elastic modulus using load displacement sensing indentation experiments. *Journal of Materials Research,* 1992, vol. 7, 1564-1583
- Metallic materials -- Instrumented indentation test for hardness and materials parameters -- Part 4: Test method for metallic and non-metallic coatings. *International Organization for Standardization,* 2007